Europäisches Patentamt

European Patent Office

Office européen des brevets

(11) Publication number: **0 469 606 A2**

## EUROPEAN PATENT APPLICATION

(21) Application number: **91112952.6**

(22) Date of filing: **01.08.91**

(51) Int. Cl.5: **H01L 21/285**, H01L 21/306, H01L 21/329, H01L 21/338

(30) Priority: **01.08.90 JP 204528/90**

(43) Date of publication of application:
**05.02.92 Bulletin 92/06**

(84) Designated Contracting States:
**DE FR GB NL**

(71) Applicant: **SUMITOMO ELECTRIC INDUSTRIES, LIMITED**
**5-33, Kitahama 4-chome Chuo-ku**
**Osaka(JP)**

(72) Inventor: **Shikata, Shin-ichi, c/o Yokohama**
**Works of Sumitomo**
**Electric Industries, Ltd. 1, Taya-cho,**
**Sakae-ku**
**Yokohama-shi, Kanagawa(JP)**

(74) Representative: **Kahler, Kurt, Dipl.-Ing.**
**Postfach 1249 Gerberstrasse 3**
**W-8948 Mindelheim(DE)**

(54) A process for forming a MES electrode.

(57) There is disclosed a process for forming a MES electrode by applying a metal material to a substrate of a III-V compound semiconductor, the metal material being in Schottky contact with the compound semiconductor, the process comprising: treating a surface of the substrate with a phosphoric acid-based etchant, and then sulfur or selenium-passivating the surface.

Fig. 1J

## Background of the Invention

(Field of the Invention)

This invention relates to a process for forming a MES (metal-semiconductor) electrode.

(Related Background Art)

It is essential to fabricate a Schottky gate field effect transistor abbreviated as MESFET, or a Schottky diode to form a MES type structure electrode. A typical semiconductor of the III-V compounds used in this device is GaAs. It is well known that the surface state density of GaAs is high as in $10^{13} \mathrm{cm}^{-2} \mathrm{eV}^{-1}$ order. Consequently in a Schottky junction formed by GaAs, the Fermi level is pinned in the gap, and the Schottky barrier height $\phi_B$ does not substantially depend any more on a work function $\phi_m$ of the metal. Resultantly when an E/D-DCFL circuit or the like is formed by GaAs, it is difficult to realize a sufficient logic amplitude, and malfunctions of the GaAs device tend to occur in high-temperature environments.

Recently noted as a countermeasure to this is sulfur passivation on the GaAs surface with ammonia sulfide containing excessive sulfur, e.g., $(NH_4)_2S_X$. This passivation terminates dangling bonds of the GaAs surface, whereby the surface states density can be decreased. Specifically, Jia-Fa FAN, "Metal-Dependent Schottky Barrier Height with the $(NH_4)_2S_X$-Treated GaAs" (Japanese Journal of Applied Physics, Vol. 27, No. 11 (November 1988), pp. L2125 - L2127) shows in FIG. 3 actual measured values of the surface states density of the sulfur-treated GaAs.

But this surface states density decrease is still insufficient and has not yet reached a degree that securely guarantees good properties of the GaAs device.

The inventors have made studies to solve the above-described problems and have achieved a process for forming a MES type structure electrode having good Schottky junction characteristics.

## Summary of the Invention

This invention relates to a process for forming a MES electrode by forming a metal material to a substrate of a III-V compound semiconductor, the metal material being in Schottky-contact with the compound semiconductor. This process is characterized in that prior to the formation of the metal material, the surface of the substrate is treated with a phosphoric acid-based etchant and there after subsequently sulfur passivated.

The compound semiconductor here is a III-V compound containing gallium (Ga) or arsenic (As), and is typically GaAs. When GaAs semiconductor crystal is sulfur-passivated, its dangling bonds are terminated with the result that the surface states density is decreased. When GaAs is treated with a phosphoric acid-based etchant prior to the sulfur passivation, the surface layer of the GaAs semiconductor crystal is removed, with the result that the effect of the surface states density decrease is augmented.

The formation of the metal material in Schottky contact is achieved by various processes. Sputtering, especially ECR sputtering, does not spoil the effect of the sulfur-passivation.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

## Brief Description of the Drawings

FIG. 1 is sectional views of a MESFET in steps of the fabrication of the MESFET which this invention can be applied to; and
FIG. 2 is a graph showing the surface states density decrease attributed to the treatment with a phosphoric acid-based etchant.

## Description of the Preferred Embodiment

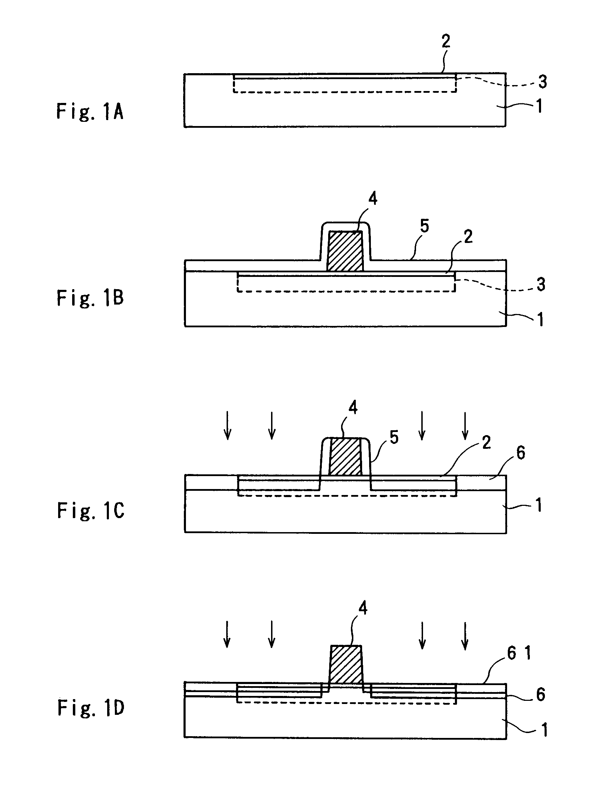

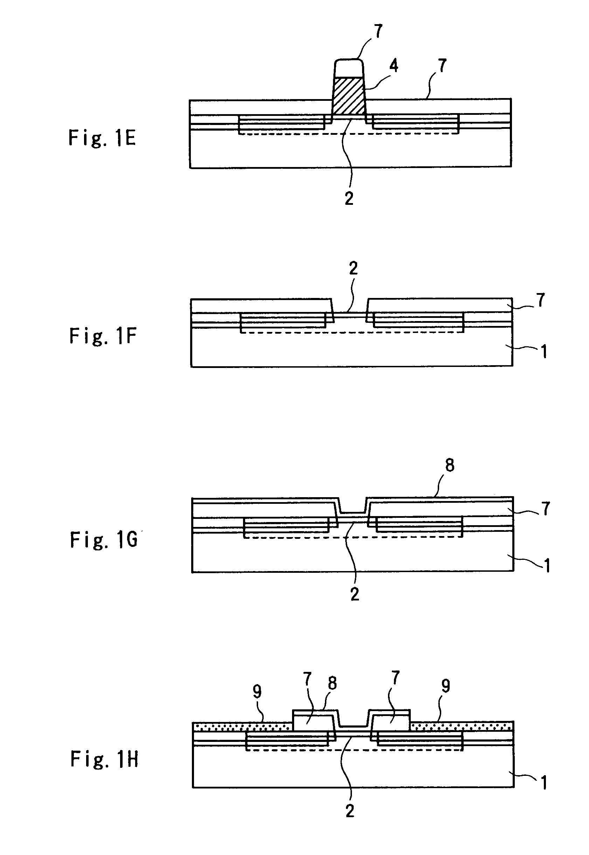

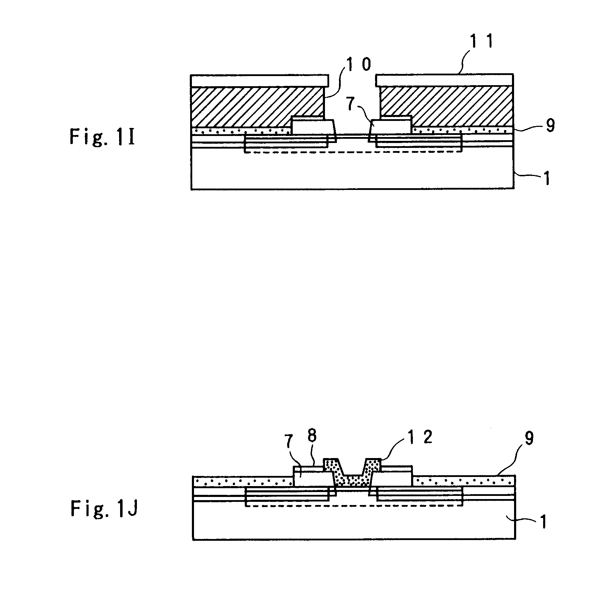

FIG. 1 is sectional views of MESFET in steps one embodiment of fabrication process of a MESFET according to the present invention. The phosphoric acid-based etchant treatment and the sulfur passivation are applied in the step of FIG. 1I. First, ions are implanted to form an $n^-$-active layer 2 and a $p^-$-buffer layer 3 on a GaAs substrate 1 (FIG. 1A). A resist mask 4 is formed on a gate electrode forming region, and a SiN film 5 is deposited on the entire surface (FIG. 1B). Only the part of the SiN film 5 on the side walls of the resist mask 4 are left on, and ions are implanted to form an $n^+$-contact region 6 (FIG. 1C). Then the left SiN film 5 is completely removed, and ions are implanted to form an n-region 61, and an LDD (lightly doped drain) structure is prepared (FIG. 1D).

Then a SiN resist film 7 is formed on the entire

surface (FIG. 1E), and the resist mask 4 is removed to form an inverting mask (FIG. 1F). Next, a $SiO_2$ film 8 is deposited on the entire surface (FIG. 1G), and the SiN film 7 and the $SiO_2$ film 8 are removed with the parts of the films near a gate electrode forming region left on. Then a Ge layer 9 is formed to form a source and a drain electrodes (FIG. 1H).

Subsequently, a resist film 10 and a $SiO_2$ film 11 are deposited on the entire surface, and the parts of the resist film 10 and the $SiO_2$ film 11 in the gate electrode forming region are removed to form a through hole. (FIG. 1I). Thus, the $n^-$-active layer 2 is exposed and is subjected to the treatment with a phosphoric acid-based etchant and the sulfur passivation characterizing this embodiment. In the treatment with a phosphoric acid-based etchant, light etching is performed with a phosphoric acid-based etchant comprising, e.g., $H_3PO_4$, $H_2O_2$ and $H_2O$, and the surface film of the $n^-$-active layer 2 is removed. Then, in the passivation following cleaning, the whole is immersed in a solution of, e.g., $(NH_4)_2S_X$ ($1 \leq x \leq 3$) to terminate the dangling bonds. Then after cleaning, next steps follow.

That is, an electrode material is deposited using the resist film 10, or the resist film 10 and the $SiO_2$ film 11 as a mask, and a gate electrode 12 is formed. Then the resist film 10 and the $SiO_2$ film 11 are removed, and a MESFET of FIG. 1J is fabricated. The gate electrode 12 is formed by, e.g., ECR sputtering.

For this embodiment, the inventors made various studies to find optimum conditions.

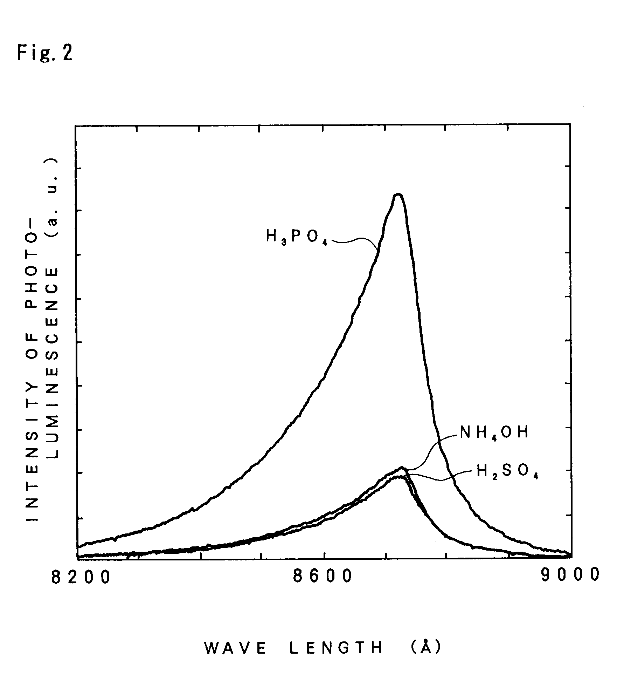

First, before the sulfur passivation, intensity of photoluminescence (PL) was compared in the removal of the surface film of the $n^-$-active layer 2 among a phosphoric acid-based etchant, an ammonium-system etchant, and a sulfuric acid-based etchant. The comparison result is shown in FIG. 2. As seen in FIG. 2, it was found that the intensity of the PL corresponding to the GaAs bandedge was improved by 3 to 4 times, compared with that in the treatment with the so-called anisotropic etchant comprising $H_2SO_4$ or $NH_4OH$ as a main component. In other words, it was indirectly confirmed that the use of the so-called isotropic etchant, such as phosphoric acid-based etchants, could drastically reduce the surface states of density of the $n^-$-active layer of GaAs. Here the anisotropic etchant means one that finishes an etched surface in normal and inversed mesas, and the isotropic etchant means one that forms a generally normal mesa shape in the etching surface in all direction.

Next, it was found that a material having a large work function $\phi_m$ was suitable as the metal material for the gate electrode 12, specifically the use of Pt (platinum), Pd (palladium), W (tungsten),

WSi (tungsten silicide), WAl (tungsten aluminum) might suppress the degradation in the effect of the sulfur treatment. It was found that sputtering was the most preferable in terms of maintenance of the effect of the sulfur treatment, and especially ECR sputtering did not reduce at all the effect of the reduction of the surface states by the sulfur treatment. This will be the reason why in the film forming device for ECR sputtering, the plasma generating reaction and the film forming reaction are performed in different chambers, and consequently the surface of GaAs semiconductor is not easily damaged by the plasma.

Finally, the inventors test-formed a MES electrode as follows.

$$H_3PO_4 : H_2O_2 : H_2O = 4 : 1 : 1000$$

In the embodiment, first in the step of FIG. 1I, the part of the GaAs active layer in the opening was etched for 15 seconds. Immediately after water-cleaning, the whole was immersed in a solution of $(NH_4)_2S_X$ for 3 minutes and water-cleaned for 15 seconds. Then a Pt gate electrode was formed by sputtering. The Schottky barrier height was $\phi_B = 1.09$ V. As a control, the MES type structure electrode of FIG. 1I was formed without the treatment with a phosphoric acid-based etchant. The Schottky barrier height for this control was $\phi_B = 0.9-0.95$ V. The advantageous effect of improving the Schottky barrier height could be confirmed.

In the above embodiment, sulfur passivation treatment is applied to a surface of the semiconductor after etching treatment with a phosphoric acid-based etchant. Selenium is one element of group VI in which sulfur is included and therefore has chemical properties similar to that of sulfur. Further, atomic radius of selenium is nearer to those of Ga and As than that of sulfur and therefore it is possible that selenium surface layer has lower energy level than that of sulfur surface layer and as the result is more stable than the sulfur surface layer. See Journal of Applied physics Vol. 67 No. 1, 1 January 1990, pages 586 to 588, "Enhanced electronic properties of GaAs surface chemically passivated by selenium reactions". In view of the above the passivation treat meet using selenium can be applied to the surface of the semiconductor substrate instead of the sulfur passivation treatment of the above embodiment and the advantageous effect in the surface states density which is obtained by the sulfur passivation may be also obtained by the selenium passivations.

As described above in detail, according to this invention, the treatment with a phosphoric acid-based etchant is performed prior to the sulfur passivation. Consequently the surface states density of a III-V compound semiconductor, e.g., GaAs semiconductors, can be reduced. Resultantly a MES electrode having good Schottky characteristics can be fabricated.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

**Claims**

1. A process for forming a MES electrode by applying a metal material to a substrate of a III-V compound semiconductor, the metal material being in Schottky contact with the compound semiconductor, the process comprising: treating a surface of the substrate with a phosphoric acid-based etchant, and then sulfur-passivating the surface.

2. A process for forming a MES electrode according to claim 1, wherein the compound semiconductor contains at least one of gallium and arsenic.

3. A process for forming a MES electrode according to claim 1 or 2, wherein the treatment with a phosphoric acid-based etchant is immersion in an etchant comprising $H_3PO_4$, $H_2O_2$ and $H_2O$.

4. A process for forming a MES electrode according to any of claims 1 to 3, wherein the sulfur passivation is a treatment for exposing the surface of the substrate to ammonium sulfide.

5. A process for forming a MES electrode according to any of claims 1 to 3, wherein the sulfur-passivation is for immersion in ammonia sulfide solution containing excessive sulfur.

6. A process for forming a MES electrode according to any preceding claim, wherein the metal material contains any one of platinum, palladium, tungsten, tungsten silicate or tungsten aluminum.

7. A process for forming a MES electrode according to any preceding claim, wherein the metal material is applied by ECR sputter.

8. A process for forming a MES electrode by applying a metal material to a substrate of a III-V compound semiconductor, the metal material being in Schottky contact with the compound semiconductor, the process comprising: treating a surface of the substrate with a phosphoric acid-based etchant, and then selenium-passivating the surface.

9. A process for forming a MES electrode by applying a metal material to a substrate of a III-V compound semiconductor, the metal material being in Schottky contact with the compound semiconductor, the process comprising: treating a surface of the substrate with a phosphoric acid-based etchant, and then passivating the surface with an element of group VI, preferably one having similar characteristics as sulfur or selenium.

Fig. 1A

Fig. 1B

Fig. 1C

Fig. 1D

Fig. 1E

Fig. 1F

Fig. 1G

Fig. 1H

Fig. 1I

Fig. 1J

Fig. 2